# EUROPÄISCHE PATENTANMELDUNG

(11) **EP 4 068 588 A1**
(43) Veröffentlichungstag der Anmeldung: **05.10.2022**
(21) Anmeldenummer: 22160051.3
(22) Anmeldetag: 03.03.2022
(51) Int. Cl.: H02K 7/14, H02K 11/33, H05K 1/02, H05K 7/14

(54) **LEITERPLATTE FÜR EINEN ELEKTROMOTOR**

(30) Priorität: 24.03.2021 DE 102021107354
(71) Anmelder: EBM-PAPST ST. GEORGEN GMBH & CO. KG, 78112 St. Georgen (DE)
(72) Erfinder: BRUCKER, Tobias, 78730 Lauterbach (DE); LANGENECK, Gunter, 78056 Villingen-Schwenningen (DE); MAYER, Stefan, 78086 Brigachtal (DE)
(74) Vertreter: Staeger & Sperling Partnerschaftsgesellschaft mbB

(57) **Zusammenfassung**

Die Erfindung betrifft eine Leiterplatte für einen Elektromotor umfassend einen Leiterplattenkörper mit einer darauf angeordneten Leistungselektronik mit Elektronikbauelementen, wobei der Leiterplattenkörper einen geometrischen Positionsmarker aufweist, der ausgebildet ist, die Leiterplatte in einer bestimmten festgelegten Position an einer Haltevorrichtung zu anzuordnen, wobei bei dem geometrischen Positionsmarker zumindest eines der Elektronikbauteile angeordnet ist und mit dem Positionsmarker derart zusammenwirkt, dass die Leiterplatte nur in der festgelegten Position an der Haltevorrichtung anordenbar ist.

## Beschreibung

Die Erfindung betrifft eine Leiterplatte für einen Elektromotor insbesondere zum Antrieb eines Ventilators sowie einen Ventilator mit einem oder mehreren Elektromotoren zum Antrieb eines oder mehrerer Ventilatorräder.

Leiterplatten mit die Leistungselektronik bildenden Elektronikbauteilen sind aus dem Stand der Technik bekannt. Dabei werden für den Leiterplattenkörper unterschiedliche Konturen und für die Leistungselektronik unterschiedliche Bestückungen vorgesehen. Die verschiedenen Bestückungen werden hierbei teils auch verwendet, die Einbauposition der Leiterplatte festzulegen.

Der Erfindung liegt die Aufgabe zugrunde, eine alternative Leiterplatte bereit zu stellen, welche eine eindeutig festgelegte Montageposition bietet und eine Fehlmontage verhindert.

Diese Aufgabe wird durch die Merkmalskombination gemäß Patentanspruch 1 gelöst.

Erfindungsgemäß wird eine Leiterplatte für einen Elektromotor umfassend einen Leiterplattenkörper mit einer darauf angeordneten Leistungselektronik mit Elektronikbauelementen vorgeschlagen. Der Leiterplattenkörper weist einen geometrischen Positionsmarker auf, der ausgebildet ist, die Leiterplatte in einer bestimmten festgelegten Position an einer Haltevorrichtung anzuordnen. Bei dem geometrischen Positionsmarker ist zumindest eines der Elektronikbauteile angeordnet und wirkt mit dem Positionsmarker derart zusammen, dass die Leiterplatte nur in der festgelegten Position an der Haltevorrichtung anordenbar ist. Als Haltevorrichtung können beliebige Trägerkonstruktionen zum Tragen der Leiterplatte eingesetzt werden, die vorzugsweise von Teilen des Elektromotors oder von Bauteilen des den Elektromotor nutzenden Gesamtaufbaus wie beispielsweise einem Ventilator bereitgestellt werden.

Die Leiterplatte kann hinsichtlich der geometrischen Form bzw. Kontur identisch ausgebildet sein und somit kostengünstig in hoher Stückzahl gefertigt werden, ohne dass individuelle Anforderungen an bestimmte Montagepositionen erfüllt werden müssen. Über den Positionsmarker wird die Montageposition der Leiterplatte an der Haltevorrichtung bestimmt. Das mindestens eine mit dem Positionsmarker zusammenwirkende Elektronikbauteil der Bestückung der Leiterplatte verhindert eine Montage der Leiterplatte in einer anderen Position als der vorab festgelegten. Die Leiterplatte ist mithin für ihre definierte Einbauposition codiert.

In einer Ausführung der Leiterplatte ist vorgesehen, dass der Positionsmarker an einem Umfangsrand des Leiterplattenkörpers ausgebildet ist. Die Leiterplatte wird zur Montage in die Haltevorrichtung gesteckt. Der Positionsmarker am Umfangsrand des Leiterplattenkörpers bietet somit die konstruktiv einfache Lösung, den Leiterplattenkörper und die Haltevorrichtung geometrische aufeinander abzustimmen.

In einer günstigen Ausführung ist die Leiterplatte dadurch gekennzeichnet, dass der Positionsmarker als Aussparung in dem Leiterplattenkörper ausgebildet ist. Ferner ist hierbei günstig, wenn eines der Elektronikbauteile die Aussparung überstreckt, so dass ein Positionierelement der Haltevorrichtung in die Aussparung nur in der festgelegten Position der Leiterplatte anordenbar oder einführbar ist und andernfalls an dem Elektronikbauteil anschlägt, bevor die festgelegte Position erreicht ist. Die Leiterplatte kann somit nur in der einen festgelegten Montageposition angeordnet und befestigt werden. Andernfalls würde das Elektronikbauteil mit dem Positionierelement auf Anschlag gehend konfligieren und eine Anordnung am Zielort verhindern. Als Positionierelement kann beispielsweise ein Steg, Stift oder Wulst vorgesehen werden.

Ein Ausführungsbeispiel der Leiterplatte sieht vor, dass die Aussparung als Schlitz ausgebildet ist. In einer alternativen Ausbildung ist die Aussparung eine Nut, beispielsweise als gelöst als Einfräsung oder Durchgangsnut bzw. als Langloch. Derartige Lösungen lassen sich kostengünstig beispielsweise am Umfangsrand des Leiterplattenkörpers realisieren.

In einer günstigen Lösung der Leiterplatte ist das zumindest eine Elektronikbauteil ein oberflächenmontiertes Bauelement, auch bekannt als surfacemounted device oder SMD-Bauteil. SMD-Bauteile werden direkt auf den Leiterplattenkörper gelötet und können hinsichtlich ihrer Position variabel gesetzt werden. SMD Bauteile haben auch eine ausreichend große Erstreckung und einen ausreichend großen Halt am Leiterplattenkörper, um die Aussparung zu überstrecken, gleichzeitig mit dem Positionierelement zusammenzuwirken und dabei nicht beschädigt zu werden oder abzufallen, wenn eine Fehlmontage verhindert werden muss. Bei einer derartigen Fehlmontage würde das Positionierelement in die Aussparung eingreifen und vor Erreichen der Montageendposition der Leiterplatte gegen das SMD-Bauteil treffen, so dass die Leiterplatte die Endposition nicht erreichen kann. Dem Montierenden ist damit klar, dass die Leiterplattenposition falsch gewählt wurde und diese beispielsweise einmal gedreht positioniert werden muss.

Die Erfindung umfasst zudem einen Ventilator mit einem Elektromotor zum Antrieb eines Ventilatorrades, einer vorstehend beschriebenen Leiterplatte und mit einer Haltevorrichtung, welche das Positionierelement bestimmt. Die Leiterplatte kann dabei am Elektromotor oder an dem Ventilator angeordnet sein.

In einer Weiterbildung wird ein Ventilator mit mehreren Elektromotoren zum Antrieb mehrerer Ventilatorräder und mit je einer Leiterplatte für je einen Elektromotor vorgeschlagen, wobei die Haltevorrichtung für jede der Leiterplatten durch ein Gehäuse des Ventilators gebildet ist. Wenn mehrere Motoren und mehrere Leiterplatten zum Einsatz kommen, spielt die richtige Montage der jeweiligen Leiterplatte richtig zugeordnet zum jeweils richtigen Elektromotor eine besonders wichtige Rolle. Die Elektronikbauteile können sich auf den jeweiligen Leiterplatten unterscheiden. Über den Positionsmarker kann an zumindest einer der Leiterplatten eine eindeutige Zuweisung an eine festgelegte Position erreicht werden. Dabei wird vorzugsweise vorgesehen, dass jede der Leiterplatten den identischen Positionsmarker aufweist, jedoch über das am geometrischen Positionsmarker angeordnete Elektronikbauteil die jeweilige Leiterplatte in nur einer bestimmten Position anordenbar und befestigbar ist. Ein Vertausch der Leiterplatten durch den Montierenden wird mithin ausgeschlossen.

Vorzugsweise ist bei dem Ventilator vorgesehen, dass das Positionierelement als Steg oder Stift ausgebildet ist, der in der bestimmten festgelegten Position der Leiterplatte in den die Aussparung eingreift, ohne das mit der Aussparung zusammenwirkende Elektronikbauteil zu berühren. Sollte eine Berührung erfolgen, wird hierdurch dem Montierenden die fehlerhafte Positionierung der Leiterplatte angezeigt.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: ein Ausführungsbeispiel einer Leiterplatte gesehen auf deren Vorderseite;
- Fig. 2: die Rückseite der Leiterplatte aus Figur 1 ;
- Fig. 3: ein Ausführungsbeispiel eines Ventilators mit der Leiterplatte aus den Figuren 1 und 2;

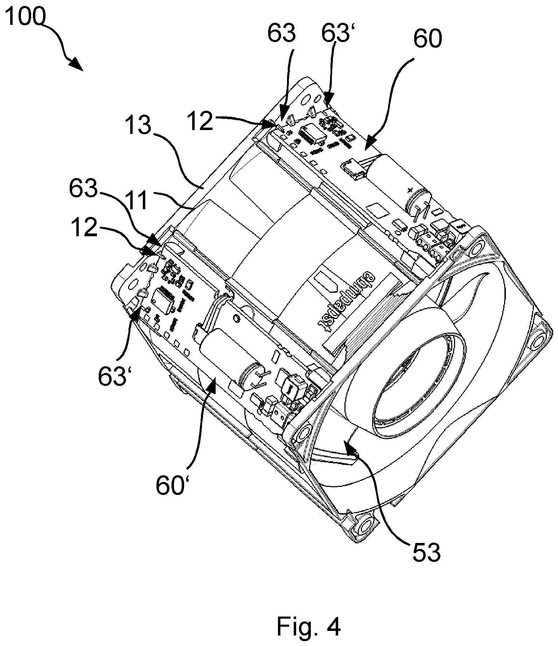

- Fig. 4: ein Ausführungsbeispiel eines Ventilators mit mehreren Leiterplatten.

Die Figuren sind beispielhaft schematisch. Gleiche Bezugszeichen in den Figuren weisen auf gleiche funktionale und/oder strukturelle Merkmale hin.

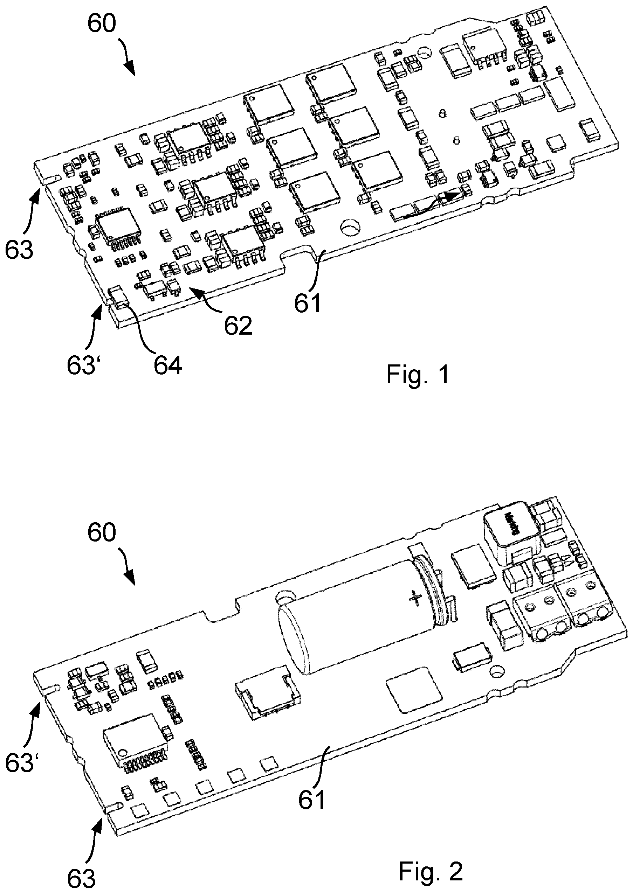

Die Figuren 1 und 2 zeigen Vorder- und Rückseite einer Leiterplatte 60 für einen Elektromotor. Auf dem Leiterplattenkörper 61 sind beidseitig eine Vielzahl von Elektronikbauelementen 62 unter anderem in Form von SMD-Bauteilen angeordnet, welche unter anderem die Leistungselektronik für den Elektromotor, aber auch Anschlussbuchsen für Wicklungsstecker etc. bilden. Am Umfangsrand sind an dem Leiterplattenkörper 61 zwei Aussparungen 63, 63' in Form von Schlitzen ausgebildet, welche als geometrischer Positionsmarker dienen. An der Aussparung 63' ist eines der SMD-Bauteile 64 die Aussparung 63' brückenartig übergreifend positioniert, so dass die Aussparung 63' auf der Vorderseite von dem SMD-Bauteil 64 versperrt ist. Ein an einer Haltevorrichtung, beispielsweise einem Träger des Elektromotors, ausgeführte und das Positionierelement bildende geometrische Form kann somit in die Aussparung 63' nur von der Rückseite eingreifen. Mithin ist die Positionierung der Leiterplatte 60 zu einer Haltevorrichtung festgelegt.

Figur 2 zeigt eine konkrete Ausführung dieser Festlegung der Montageposition anhand eines Ventilators 10, der einen Elektromotor zum Antrieb eines Ventilatorrades aufweist. Das Gehäuse 11 des Ventilators 10 bildet die Haltevorrichtung für die Leiterplatte 60, welche mit dem Anschlussstecker 33 des Ventilators 10 verbunden ist. An dem Gehäuse ist einseitig als Positionierelement ein Steg 12 ausgebildet, der nur in die Aussparung 63 eingreifen kann, bei der das Elektronikbauteil 64 nicht verbaut ist. Die Leiterplatte 60 wird mithin festgelegt als mit ihrer Rückseite nach außen weisend montiert. Eine Anordnung der Leiterplatte 60 in dem Gehäuse 11 mit der Vorderseite nach außen weisend wird dadurch verhindert, dass der Steg 12 gegen das SMD-Bauteil 64 treffen und ein Einrasten der Leiterplatte 60 im Gehäuse 11 verhindern würde.

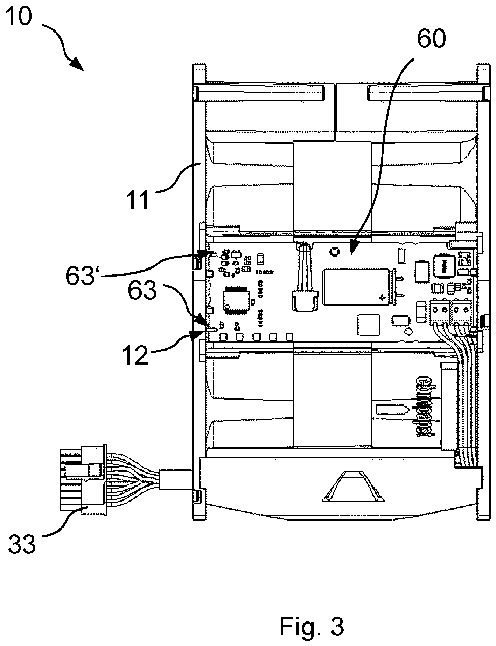

In Figur 3 ist ein Ausführungsbeispiel eines Ventilators 100 mit zwei Leiterplatten 60, 60' dargestellt. Die beiden Leiterplatten 60, 60' sind je einem Elektromotor zugeordnet, der jeweils ein Ventilatorrad 53 antreibt. Bei diesem Ausführungsbeispiel sind an dem Gehäuse 11 des Ventilators 100 als Positionierelement jeweils ein Steg 12 bzw. ein Schenkel ausgebildet, welcher die Aussparung 63 jeweils vollständig durchdringt und die Position der Leiterplatten 60, 60' jeweils eindeutig dadurch festlegt, dass der Steg 12 einmal linksseitig und einmal rechtsseitig in die Aussparung 63' eingreift. Eine Fehlmontage der Leiterplatte 60 anstelle der Leiterplatte 60' ist somit ausgeschlossen. Die zweite Aussparung 63' mit dem übergreifenden SMD-Bauteil 64 bleibt in der richtigen Montageposition, bei der wie gezeigt beide Leiterplatten 60, 60' bis zu dem Flansch 13 zur Anlage gebracht sind, jeweils leer. Die Leiterplattenkörper 61 sind formgleich und mit identischen Aussparungen 63, 63' versehen, um eine hohe Stückzahl gleicher Bauteile fertigen zu können.

Auch wenn vorliegend in den Figuren als Aussparung 63, 63' Schlitze gezeigt sind, können auch eingesenkte Nuten verwendet werden. Ferner ist die geometrische Form der Aussparungen und Stege nicht auf die Schlitzform und Stegform beschränkt, vielmehr können auch andere zueinander passende Geometrien eingesetzt werden. Als Haltevorrichtung wird für die Leiterplatten vorzugsweise ein Gehäuse verwendet, jedoch kann die Anordnung auch direkt am Elektromotor oder an anderen externen Bauteilen erfolgen.

## Patentansprüche

1. Leiterplatte (60) für einen Elektromotor umfassend einen Leiterplattenkörper (61) mit einer darauf angeordneten Leistungselektronik mit Elektronikbauelementen (62), wobei der Leiterplattenkörper (61) einen geometrischen Positionsmarker aufweist, der ausgebildet ist, die Leiterplatte (60) in einer bestimmten festgelegten Position an einer Haltevorrichtung zu anzuordnen, wobei bei dem geometrischen Positionsmarker zumindest eines der Elektronikbauteile (64) angeordnet ist und mit dem Positionsmarker derart zusammenwirkt, dass die Leiterplatte (60) nur in der festgelegten Position an der Haltevorrichtung anordenbar ist.

2. Leiterplatte nach Anspruch 1, **dadurch gekennzeichnet, dass** der Positionsmarker an einem Umfangsrand des Leiterplattenkörpers (61) ausgebildet ist.

3. Leiterplatte nach Anspruch 1 oder 2, **dadurch gekennzeichnet, dass** der Positionsmarker als Aussparung (63') in dem Leiterplattenkörper (61) ausgebildet ist.

4. Leiterplatte nach dem vorigen Anspruch, **dadurch gekennzeichnet, dass** eines der Elektronikbauteile die Aussparung (63') überstreckt, so dass ein Positionierelement der Haltevorrichtung in die Aussparung (63') nur in der festgelegten Position der Leiterplatte (60) anordenbar oder einführbar ist und andernfalls an dem Elektronikbauteil (64) anschlägt, bevor die festgelegte Position erreicht ist.

5. Leiterplatte nach einem der vorigen Ansprüche 3 oder 4, **dadurch gekennzeichnet, dass** die Aussparung (63') als Schlitz ausgebildet ist.

6. Leiterplatte nach einem der vorigen Ansprüche 3 oder 4, **dadurch gekennzeichnet, dass** die Aussparung (63') als Nut ausgebildet ist.

7. Leiterplatte nach einem der vorigen Ansprüche 3 bis 6, **dadurch gekennzeichnet, dass** die Aussparung (63, 62') form identisch mehrfach vorgesehen ist.

8. Leiterplatte nach einem der vorigen Ansprüche, **dadurch gekennzeichnet, dass** das zumindest eine Elektronikbauteil (64) ein oberflächenmontiertes Bauelement (SMD-Bauteil) ist.

9. Ventilator (10, 100) mit einem Elektromotor zum Antrieb eines Ventilatorrades, einer Leiterplatte (60) nach einem der vorigen Ansprüche und mit einer Haltevorrichtung, welche das Positionierelement bestimmt.

10. Ventilator (100) mit mehreren Elektromotoren zum Antrieb mehrerer Ventilatorräder und mit je einer Leiterplatte (60) für je einen Elektromotor, wobei zumindest eine der Leiterplatten (60) nach einem der vorigen Ansprüche 1 bis 7 ausgebildet ist, wobei die Haltevorrichtung für jede der Leiterplatten (60) durch ein Gehäuse (11) des Ventilators gebildet ist.

11. Ventilator (10, 100) nach einem der Ansprüche 8 oder 9, **dadurch gekennzeichnet, dass** das Positionierelement als Steg (12) ausgebildet ist, der in der bestimmten festgelegten Position der Leiterplatte (60) in die Aussparung (63, 63') eingreift, ohne das mit der Aussparung (63') zusammenwirkende Elektronikbauteil (64) zu berühren.
